(19) Europäisches Patentamt European Patent Office Office européen des brevets

(11) **EP 4 722 427 A1**

(12) **EUROPEAN PATENT APPLICATION**
published in accordance with Art. 153(4) EPC

(43) Date of publication:
**08.04.2026 Bulletin 2026/15**

(21) Application number: **24815341.3**

(22) Date of filing: **22.05.2024**

(51) International Patent Classification (IPC):
**C30B 29/30** (2006.01)

(52) Cooperative Patent Classification (CPC):
**C30B 29/30**

(86) International application number:
**PCT/JP2024/018912**

(87) International publication number:
**WO 2024/247857 (05.12.2024 Gazette 2024/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.05.2023 JP 2023090005**

(71) Applicant: SUMITOMO METAL MINING CO., LTD.
**Tokyo**
**105-8716 (JP)**

(72) Inventors:
• YAMAKI, Ryota
**Isa-shi, Kagoshima 895-2501 (JP)**
• KOMI, Toshiyuki
**Isa-shi, Kagoshima 895-2501 (JP)**

(74) Representative: Müller-Boré & Partner
**Patentanwälte PartG mbB**
**Friedenheimer Brücke 21**
**80639 München (DE)**

(54) **SINGLE-CRYSTAL LITHIUM NIOBATE, METHOD FOR PRODUCING SINGLE-CRYSTAL LITHIUM NIOBATE, AND AR GLASSES**

(57)    [Object] Provided is a lithium niobate single crystal that has low absorption of light having a wavelength in a visible light region.

[Solution] The lithium niobate single crystal has a platinum concentration in the single crystal of 1.0 ppm or less.

Fig. 1

EP 4 722 427 A1

## Description

Technical Field

The present invention relates to a lithium niobate single crystal, a method for producing a lithium niobate single crystal, and AR glasses.

Background Art

As qualities required for a waveguide material used in AR glasses (augmented reality glasses), four qualities: (1) a high refractive index, (2) low light absorption in a visible light region, (3) high flatness of a material processed into a wafer, and (4) a low specific gravity are particularly required.

The waveguide material for AR glasses is highly refractive, and thus the field of view (FOV) of an image to be displayed on AR glasses can be enlarged, and an image having a high sense of immersion and a high sense of presence can be displayed. Although a high-refractive index glass has been typical for a material used in a waveguide for AR glasses, the refractive index of the high-refractive index glass is limited to about 2.1. The use of a lithium niobate single crystal having a high refractive index of 2.2, which is higher than the high-refractive index glass, has been investigated.

A lithium niobate ($LiNbO_3$; sometimes abbreviated as LN) single crystal is an artificial ferroelectric crystal having a melting point of about 1,250°C and a Curie temperature of about 1,140°C. An LN single crystal substrate obtained by cutting out an LN single crystal followed by grinding is used as a material for a surface acoustic wave device (SAW filter) mainly mounted on a mobile communication device.

When a waveguide for AR glasses absorbs light having a wavelength in the visible light region, light is totally reflected in the waveguide and light attenuation increases upon passage of an image, and the color of an image displayed on the AR glasses differs from an intended image, which is a problem.

Patent Literature 1 discloses a method for producing a lithium niobate single crystal used in an optical element, but not in application of AR glasses, and that an oxygen concentration of 5% by volume or less during growth suppresses absorption of light having a wavelength of about 420 nm.

Citation List

Patent Literature

Patent Literature 1: Japanese Unexamined Patent Application Publication No. H01-96095

Summary of Invention

Technical Problem

It has been found that a lithium niobate single crystal produced by the production method described in Patent Literature 1 absorbs light having a wavelength in the visible light region and a reduction in absorption of light having a wavelength in the visible light region remains insufficient.

An object of the present invention is to provide a lithium niobate single crystal that has low absorption of light having a wavelength in the visible light region. Solution to Problem

The present inventors have intensively studied, and as a result, found that the light absorption coefficient at a wavelength of about 470 nm of a lithium niobate single crystal is affected by a platinum impurity in the crystal. The present invention has been completed on the basis of these findings.

A lithium niobate single crystal of an aspect of the present invention has a platinum concentration in the single crystal of 1.0 ppm or less. The lithium niobate single crystal preferably has a platinum concentration in the single crystal of 0.5 ppm or less.

Further, the lithium niobate single crystal of the aspect of the present invention has a difference between a light absorption coefficient at a wavelength of 470 nm and a light absorption coefficient at a wavelength of 600 nm of 0.01 $cm^{-1}$ or less.

Furthermore, the lithium niobate single crystal of the aspect of the present invention preferably has a light absorption coefficient at a wavelength of 470 nm of 0.01 $cm^{-1}$ or less.

Moreover, in AR glasses of an aspect of the present invention, the lithium niobate single crystal of the aspect is used as a waveguide.

A method for producing the lithium niobate single crystal of the aspect of the present invention is a method for producing a lithium niobate single crystal including adjusting a content of platinum in a crucible so that a platinum concentration in a grown single crystal is 1.0 ppm or less, the crucible being used in growth of the single crystal and containing platinum as a material.

Effects of Invention

The aspect of the present invention can provide a lithium niobate single crystal that has low absorption of light having a wavelength in a visible light region. Further, according to the method for producing a lithium niobate single crystal of the aspect of the present invention, the lithium niobate single crystal of the aspect of the present invention can be produced. The AR glasses of the aspect of the present invention have low absorption of light having a wavelength in a visible light region at a waveguide.

Brief Description of the Drawings

[FIG. 1] A cross-sectional view schematically illustrating an example of a schematic configuration of a single crystal growth apparatus by the Czochralski method.
[FIG. 2] A schematic view illustrating measurement of a reflectance and a transmittance with a spectrophotometer to calculate an absorption coefficient.

Description of Embodiments

Hereinafter, specific embodiments of the present invention will be described in detail. The present invention is not limited to the following embodiments, and the present invention may be appropriately changed within a range that does not change the spirit of the present invention. In each drawing, a part or all of components are schematically described as appropriate and described with the scale changed. For ease of understanding of the description, the same components are given the same reference numerals in each drawing as much as possible, and duplicated description is omitted. In the following description, the expression "A to B" means "A or more and B or less."

[Summary of Single Crystal Growth Apparatus and Single Crystal Growth Method]

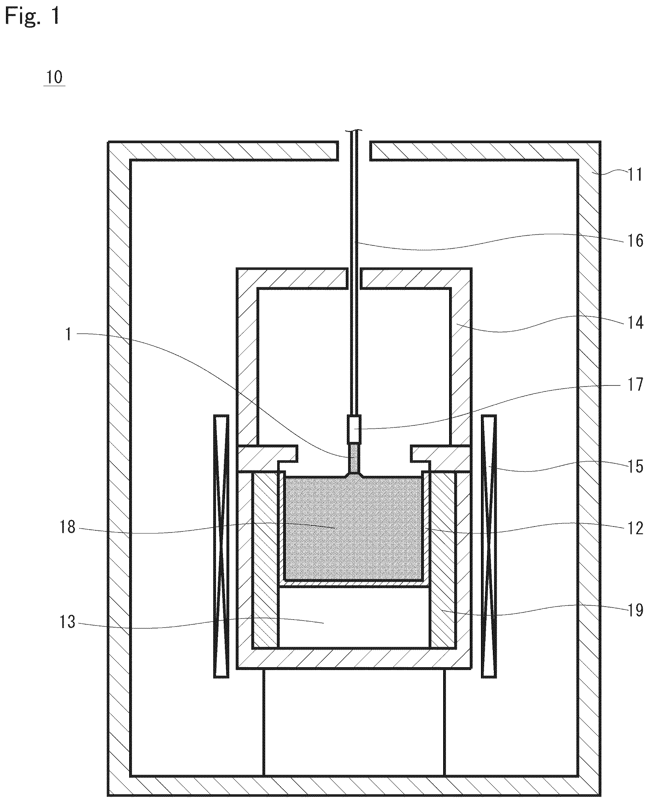

First, the summary of a single crystal growth apparatus and a single crystal growth method for a lithium niobate single crystal will be described. Examples of a typical procedure for growing a crystal of a lithium niobate single crystal include the Czochralski method (Cz method) and the vertical Bridgman method (VB method).
In the following, a configuration example of a single crystal growth apparatus 10 by the Czochralski method (Cz method) and the summary of a single crystal growth method will be described with reference to FIG. 1.
FIG. 1 is a cross-sectional view schematically illustrating an example of a schematic configuration of a high-frequency inductive heating type single crystal growth apparatus. The example illustrated in FIG. 1 is a high-frequency inductive heating type single crystal growth apparatus, but a resistive heating type single crystal growth apparatus is also used in growth of an LN single crystal. The difference between the high-frequency inductive heating type single crystal growth apparatus and the resistive heating type single crystal growth apparatus is as follows. In the case of the high-frequency inductive heating type single crystal growth apparatus, an eddy current is generated in a side wall of a metal crucible 12 provided in a work coil 15 under a high-frequency magnetic field generated by the work coil 15, and the crucible 12 itself functions as a heating element due to the eddy current and forms a temperature environment required for melting of a raw material in the crucible 12 and crystal growth. In the case of the resistive heating type single crystal growth apparatus, a temperature environment required for melting of a raw material and crystal growth is formed under heat generated by a resistive heating heater provided at the outer periphery of the crucible. The essence of the Cz method does not change regardless of which heating type is adopted, and thus an example of a single crystal growth method using the high-frequency inductive heating type single crystal growth apparatus will be described below.
As illustrated in FIG. 1, the crucible 12 is disposed in a chamber 11 of the high-frequency inductive heating type single crystal growth apparatus 10. As the crucible 12, for example, a crucible having a diameter of about 150 mm to 300 mm and a depth of about 150 mm to 300 mm is used. The crucible is placed on a crucible stage 13 as illustrated in FIG. 1. In the chamber 11, a fire-proof member 14 is disposed so as to surround the crucible 12. The work coil 15 is disposed so as to surround the crucible 12, an eddy current flows in the wall of the crucible 12 under a high-frequency magnetic field generated by the work coil 15, and the crucible 12 itself functions as a heating element. A pulling shaft (seed rod) 16 is disposed at the upper portion of the chamber 11 so as to be rotatable and movable in a vertical direction. A seed holder 17 to hold a seed crystal 1 is attached to an end portion of the lower edge of the pulling shaft (seed rod) 16.
In the Cz method, a single crystal fragment to become the seed crystal 1 is brought into contact with the surface of a melt of a single crystal material 18 in the crucible 12, and the seed crystal 1 is pulled up while the seed crystal 1 is rotated by the pulling shaft (seed rod) 16, to grow a cylindrical single crystal having the same orientation as the crystal orientation of the seed crystal 1.

In the Cz method, the rotation speed and the pull-up speed of the seed crystal 1 depend on the kind of a crystal to be grown and a temperature environment during growth, and need to be appropriately selected according to the conditions. Further, latent heat of solidification generated by crystallization of the melt on a growth interface needs to be allowed to escape upward through the seed crystal during crystal growth, and thus the crystal growth needs to be performed under a temperature gradient in which the temperature reduces upward from the growth interface. In addition, in order to prevent the shape of a grown crystal from bending or twisting, the crystal growth needs to be performed under a temperature gradient in which the temperature increases in a horizontal direction from the growth interface toward the wall of the crucible and in a perpendicular direction from the growth interface toward the bottom of the crucible.

In the case of growing an LN single crystal, the crucible 12 made of platinum (Pt) that has a melting point of about 1,760°C and is chemically stable is used since the LN crystal has a melting point of 1,250°C. The growth is performed generally at a pull-up speed of several millimeters per hour and a rotation speed of several to several tens of rpm (e.g., 3 rpm to 10 rpm). Further, the atmosphere of a growth furnace during the growth is generally air or an atmosphere of mixed gas of nitrogen and oxygen at an oxygen concentration of about 20%. Under such conditions, a crystal is grown to a desired size, the grown crystal is detached from the melt by performing an operation such as changing the pull-up speed or gradually increasing the melt temperature, and the power of the growth furnace is reduced at a predetermined speed to gradually cool the temperature. After the temperature in the growth furnace is cooled near room temperature, the crystal is removed from the growth furnace.

The crystal that has been grown by this method and removed from the furnace is subjected to annealing treatment to eliminate residual strain caused by a temperature difference in the crystal, and a poling treatment for aligning the direction of spontaneous polarization in the crystal, and then delivered to substrate processing steps such as slicing and grinding.

The aforementioned method for producing an LN single crystal is a method for producing an LN single crystal used as a material for a surface acoustic wave device (SAW filter). When an LN single crystal produced by this method is used as a waveguide material for AR glasses, it has been found that the LN single crystal produced in the foregoing has a light absorption peak at a specific wavelength in the visible light region, light is totally reflected in the waveguide and light attenuation increases at the specific wavelength upon passage of an image, and the color of an image displayed on the AR glasses differs from an intended image, which is a problem. When the LN single crystal is used as a waveguide material for AR glasses, it is particularly important to reduce a difference between a light absorption coefficient at a wavelength of 470 nm and a light absorption coefficient at a wavelength of 600 nm in the visible light region.

When the present inventors studied to solve the aforementioned problem, the inventors examined the difference between the light absorption coefficient at a wavelength of 470 nm and the light absorption coefficient at a wavelength of 600 nm of the LN single crystal and an influence of an impurity in the crystal, and as a result, found a correlation with platinum (Pt). Further, the inventors found that the light absorption coefficient at a wavelength of about 470 nm of the LN single crystal is affected by a platinum (Pt) impurity in the crystal. The LN single crystal according to the embodiment and the method for producing the same have been completed by progress of further study on the basis of these findings.

The LN single crystal according to the embodiment will be described. An LN single crystal according to an aspect of the embodiment has a platinum (Pt) concentration (content) in the single crystal of 1.0 ppm or less. Further, an LN single crystal according to an aspect of the embodiment has a difference between a light absorption coefficient at a wavelength of 470 nm and a light absorption coefficient at a wavelength of 600 nm of 0.01 cm$^{-1}$ or less. Furthermore, an LN single crystal according to an aspect of the embodiment has a light absorption coefficient at a wavelength of 470 nm of 0.01 cm$^{-1}$ or less.

The LN single crystal according to the embodiment can significantly suppress the difference between the light absorption coefficient at a wavelength of 470 nm and the light absorption coefficient at a wavelength of 600 nm by suppressing the concentration of platinum (Pt) in the LN single crystal, and can significantly reduce the light absorption coefficient at a wavelength of 470 nm, as listed in Table 1 below.

The upper limit of the platinum (Pt) concentration in the LN single crystal of the embodiment is preferably 1.0 ppm or less, more preferably 0.9 ppm or less, still more preferably 0.8 ppm or less, still more preferably 0.5 ppm or less, still more preferably 0.4 ppm or less, and still more preferably 0.3 ppm or less. The upper limit of the difference between the light absorption coefficient at a wavelength of 470 nm and the light absorption coefficient at a wavelength of 600 nm in the LN single crystal is preferably 0.01 cm$^{-1}$ or less, more preferably 0.008 cm$^{-1}$ or less, still more preferably 0.005 cm$^{-1}$ or less, and still more preferably 0.004 cm$^{-1}$ or less. When the platinum (Pt) concentration in the LN single crystal is 1.0 ppm or less, the difference between the light absorption coefficient at a wavelength of 470 nm and the light absorption coefficient at a wavelength of 600 nm (sometimes described as the difference between the light absorption coefficients at wavelengths of 470 nm and 600 nm) can be reduced, for example, to 0.01 cm$^{-1}$ or less. The LN single crystal preferably has a platinum (Pt) concentration of 0.5 ppm or less. With this configuration, the difference between the light absorption coefficients at wavelengths of 470 nm and 600 nm can be further reduced, for example, to 0.005 cm$^{-1}$. The lower limit of the platinum (Pt) concentration in the LN single crystal is 0 ppm or more and may be 0.1 ppm or more. Further, the lower limit of the difference between the light absorption coefficients at wavelengths of 470 nm and 600 nm in the LN single crystal is not particularly limited, but is 0 cm$^{-1}$ or more, and may be 0.001 cm$^{-1}$ or more. The platinum (Pt) concentration in the LN single crystal is, for example, within the range of any one of the aforementioned upper limit values to any one of the lower limit values, or between any two of the aforementioned upper limit values. The difference between the light absorption coefficients at wavelengths of 470 nm and 600 nm in the LN single crystal is, for example, within the range of any one of the aforementioned upper limit values to any one of the lower limit values, or between any two of the aforementioned upper limit values. When the platinum (Pt) concentration in the LN single crystal is more than 1.0 ppm, the difference between the light absorption coefficients at wavelengths of 470 nm and 600 nm increases. When the platinum (Pt) concentration in the LN single crystal is more than 1.0 ppm, the light absorption coefficient at a wavelength of 470 nm increases, and the difference between the light absorption coefficient at a wavelength of 470 nm and the light absorption coefficient at a wavelength of 600 nm increases.

The presence of a transition metal as an impurity in the LN single crystal in addition to platinum affects the difference between the light absorption coefficients at wavelengths of 470 nm and 600 nm, and thus the concentration (content) of an element other than platinum was analyzed by ICP mass spectrometry (ICP-MS), like Examples 1 and 2 and Comparative Example 1. However, in the examples, an element exhibiting a correlation of the difference between the light absorption coefficients at wavelengths of 470 nm and 600 nm was not found. Table 2 below lists analysis results for typical transition metal elements.

The concentrations of impurities other than platinum in the LN single crystal will be described. The upper limit of a Fe concentration in the LN single crystal is preferably 2 ppm or less, and more preferably 1.5 ppm or less. The lower limit of the Fe concentration is 0 ppm or more, and may be 0.5 ppm or more or 1.0 ppm or more. In the LN single crystal, the Fe concentration is, for example, within the range of any one of the lower limit values to any one of the upper limit values. When the Fe concentration is within the aforementioned range, the light absorption coefficients at wavelengths of 470 nm and 600 nm in the visible light region are not highly affected.

The upper limit of a Ni concentration in the LN single crystal is preferably 0.2 ppm or less, and more preferably 0.1 ppm or less. The lower limit of the Ni concentration is 0 ppm or more, and may be 0.05 ppm or more. In the LN single crystal, the Ni concentration is, for example, within the range of any one of the lower limit values to any one of the upper limit values. When the Ni concentration is within the aforementioned range, the light absorption coefficients at wavelengths of 470 nm and 600 nm in the visible light region are not highly affected.

The upper limit of a Cr concentration in the LN single crystal is preferably 0.4 ppm or less, and more preferably 0.3 ppm or less. The lower limit of the Cr concentration is 0 ppm or more, and may be 0.1 ppm or more. In the LN single crystal, the Cr concentration is, for example, within the range of any one of the lower limit values to any one of the upper limit values. When the Cr concentration is within the aforementioned range, the light absorption coefficients at wavelengths of 470 nm and 600 nm in the visible light region are not highly affected.

The upper limit of a Cu concentration in the LN single crystal is preferably 0.2 ppm or less, and more preferably 0.1 ppm or less. The lower limit of the Cu concentration is 0 ppm or more, and may be 0.05 ppm or more. In the LN single crystal, the Cu concentration is, for example, within the range of any one of the lower limit values to any one of the upper limit values. When the Cu concentration is within the aforementioned range, the light absorption coefficients at wavelengths of 470 nm and 600 nm in the visible light region are not highly affected. In the LN single crystal, another element other than the aforementioned elements may be contained without departing from the spirit of the present invention.

It is important to suppress the peak of the light absorption coefficient at a wavelength of 470 nm in the LN single crystal. The light absorption coefficient at a wavelength of 470 nm in the LN single crystal may be 0.01 cm$^{-1}$ or less, and preferably 0.005 cm$^{-1}$ or less. For example, when the platinum (Pt) concentration in the single crystal is reduced, the light absorption coefficient at a wavelength of 470 nm may be 0.01 cm$^{-1}$ or less. For example, when the platinum (Pt) concentration in the single crystal is 1.0 ppm or less, the light absorption coefficient at a wavelength of 470 nm may be 0.01 cm$^{-1}$ or less. Preferably, when the platinum (Pt) concentration is 0.5 ppm or less, the light absorption coefficient at a wavelength of 470 nm may be 0.005 cm$^{-1}$ or less. The lower limit of the light absorption coefficient at a wavelength of 470 nm in the LN single crystal is not particularly limited, but is 0 cm$^{-1}$ or more, and may be 0.001 cm$^{-1}$ or more. In the LN single crystal, the light absorption coefficient at a wavelength of 470 nm is, for example, within the range of any one of the lower limit values to any one of the upper limit values. Further, the upper limit of the light absorption coefficient at a wavelength of 600 nm in the LN single crystal is not particularly limited without departing from the spirit of the present invention, but may be, for example, 0.0006 cm$^{-1}$ or less, and may be 0.0004 cm$^{-1}$ or less. Furthermore, the lower limit of the light absorption coefficient at a wavelength of 600 nm in the LN single crystal is not particularly limited without departing from the spirit of the present invention, but may be 0 cm$^{-1}$ or more, and may be 0.001 cm$^{-1}$ or more. In the LN single crystal, the light absorption coefficient at a wavelength of 600 nm is, for example, within the range of any one of the lower limit values to any one of the upper limit values.

In the present description, the concentrations (contents) of elements such as platinum (Pt) in the LN single crystal are determined by inductively coupled plasma mass spectrometry (ICP-MS). The ICP-MS can be carried out by a method described in Examples. In the present description, the light absorption coefficient is a value determined by a method described in Examples.

The shape of the LN single crystal may be an ingot, a wafer, or a thin plate. The size of the LN single crystal is not particularly limited. For example, the diameter may be 1 inch or more, or may be 6 inches or 8 inches. The thickness of the crystal is not particularly limited, but may be 100 $\mu$m or more, for example, 100 $\mu$m or more and 1,000 $\mu$m or less. For example, in the case of a wafer, the thickness may be 250 $\mu$m or more and 1,000 $\mu$m or less, and a thickness of 350 $\mu$m to 500 $\mu$m is often adopted. In the case of an ingot, the thickness may be 10 mm to 150 mm.

As described above, the LN single crystal according to the aspect of the embodiment has a platinum (Pt) concentration (content) in the single crystal of 1.0 ppm or less. Further, the LN single crystal according to the aspect of the embodiment has a difference between the light absorption coefficient at a wavelength of 470 nm and the light absorption coefficient at a wavelength of 600 nm of 0.01 cm$^{-1}$ or less. Furthermore, the LN single crystal according to the aspect of the embodiment has a light absorption coefficient at a wavelength of 470 nm of 0.01 cm$^{-1}$ or less. All the LN single crystals according to the aspects of the embodiment have characteristics of having low absorption of light having a wavelength in the visible light region.

The LN single crystal according to the embodiment has the aforementioned characteristics and thus can be suitably used for waveguides for AR display apparatuses (augmented reality display apparatuses), such as AR glasses (augmented reality glasses). For example, the AR display apparatus and the AR glasses may be configured to use the LN single crystal according to the embodiment as a waveguide. For example, in the AR display apparatus and the AR glasses, the LN single crystal of the embodiment is used for at least a part of the waveguide, the rest may be an optional configuration, and as the optional configuration, for example, a known configuration can be used. The LN single crystal has the aforementioned characteristics, and thus the LN single crystal can be suitably used for an optical element usable for visible light.

Next, the method for producing the LN single crystal according to the embodiment will be described. The LN single crystal according to the embodiment can be produced, for example, by reducing the concentration (content) of platinum (Pt) in the crystal.

Examples of a method for reducing a platinum impurity concentration in the lithium niobate single crystal include some methods. For example, when a crucible used in crystal growth includes a platinum-iridium alloy and the ratio of platinum is reduced, a lithium niobate single crystal having a low platinum impurity concentration can be obtained.

Next, the method for reducing a platinum impurity concentration in the lithium niobate single crystal will be described. It is possible that the platinum impurity in the LN single crystal is first an impurity contained in a raw material. It is also important to increase the purity of the raw material. It is preferable to use a raw material having a purity of 99.99 or more as the purity of the raw material. However, at the stage of producing the raw material, platinum is not usually used in the LN single crystal, and thus the possibility is considered unlikely.

Further, a material for a crucible during growth is important. Examples of a method for growing a crystal of a lithium niobate single crystal include the Czochralski method (Cz method) and the vertical Bridgman method (VB method) as described above. A crucible used in melting the raw material is used. As a crucible in the Cz method, a crucible made of a chemically stable material having a high melting point is generally used. Examples of the material include platinum, iridium, and an alloy thereof. In crystal growth of the LN single crystal, a platinum crucible, which is usually relatively inexpensive, is used. A platinum crucible is made of a chemically stable substance that is unlikely to be eluted into a solution, but it has been found that as listed in Table 1 below, a trace amount of the substance is eluted into a melt (raw material melt), platinum (Pt) from the crucible is incorporated into the crystal during growth and affects the light absorption coefficient.

In the embodiment, a test was performed using a crucible made of platinum or a platinum-iridium alloy as a material for a crucible, and as a result, it has been found that as the content of platinum in the platinum-iridium alloy is smaller, the elution amount into the LN single crystal is smaller. Accordingly, the method for producing an LN single crystal according to the embodiment is a method for producing an LN single crystal that may include adjusting the content of platinum in a crucible so that the platinum concentration in a grown single crystal is 1.0 ppm or less, the crucible being used in growth of the single crystal and containing platinum as a material. For example, this method can be carried out by a method described in Examples. For example, when the content of platinum in the crucible is adjusted so that the platinum concentration in the single crystal is 1.0 ppm or less, the content of platinum in the platinum-iridium alloy crucible is, for example, 50% or less, and preferably 20% or less. The elution of iridium into the LN single crystal is not sufficient to affect the light absorption coefficient in the visible light region of the LN single crystal.

Further, the oxygen concentration in a furnace during growth is generally set to an oxygen concentration in air or an atmosphere of mixed gas of nitrogen and oxygen at an oxygen concentration of about 20%. However, when iridium such as a platinum-iridium alloy is contained, it is preferable that the oxygen concentration be set to be low since iridium is bonded to oxygen to easily sublime, and it is preferable that the oxygen concentration in the furnace during growth be air having an oxygen concentration of more than 5% or an oxygen concentration of about 20% in consideration of the stability of the crystal.

In the embodiment, examples of a method for reducing a platinum impurity concentration in the lithium niobate single crystal include the example in which the platinum concentration in the alloy of the crucible is reduced, but the present invention is not limited to this example. For example, a method for producing a crystal without using platinum like a cold crucible method may be used.

As described above, the method for producing an LN single crystal according to the embodiment is a method for producing an LN single crystal including adjusting the content of platinum in a crucible so that the platinum concentration in a grown single crystal is 1.0 ppm or less, the crucible being used in growth of the single crystal and containing platinum as a material. In a configuration other than the foregoing in the method for producing an LN single crystal of the embodiment, for example, a known method can be appropriately used. According to the method for producing a lithium niobate single crystal of the embodiment, the lithium niobate single crystal of the aspect of the present invention can be produced.

Examples

Hereinafter, the present invention will be specifically described using Examples, but the present invention is not limited to the examples.

[Example 1]

The flow rates of a nitrogen gas and an oxygen gas were adjusted so that the oxygen concentration in a growth furnace was 20% with the high-frequency inductive heating type single crystal growth apparatus illustrated in FIG. 1, and an LN crystal was grown by Z-axis pulling of the Cz method. Here, the Z-axis pulling refers to the growth orientation of a crystal (the crystal orientation of a seed crystal).

For a reduction in platinum concentration in the LN crystal to be produced, the crucible 12 in which a platinum ratio of a platinum-iridium alloy was set to 20% was charged with an LN powder having a purity of 99.99 or more as the raw material 18, the raw material 18 was melted, and an end portion of the seed crystal 1 was immersed in the raw material melt in the crucible 12 and then pulled up while rotating, to grow an LN single-crystal ingot including a straight body having a diameter of 6 inches (= 152 mm) and a length of 70 mm. The grown LN single-crystal ingot was detached from the raw material melt, and the crystal was cooled to around room temperature and then taken out.

The taken single-crystal ingot was subjected to annealing and poling treatment, the outer periphery was ground into a cylinder, and the ingot was cut into wafers each having a thickness of 500 $\mu$m with a multi-wire saw. One of the wafers at a position corresponding to each of the upper portion and the lower portion of the crystal in the cut crystal was sampled, pulverized with a ball mill made of agate, and then sieved through a mesh of 150 $\mu$m, the resultant was mixed with a reagent in which hydrofluoric acid and nitric acid were mixed, and the mixture was converted to a solution with a microwave pretreatment apparatus. The platinum concentration of the sample in the solution state was analyzed by ICP-MS, and the platinum concentration in each of the wafers was 0.3 ppm. For measurement of the absorption coefficient, both surfaces of the remaining wafers were subjected to chemical mechanical polishing using colloidal silica. The absorption coefficient of the wafers after the polishing was measured with a spectrophotometer (Cary 7000 manufactured by Agilent Technologies, Inc.). In this example, the analysis precision of elements by ICP-MS was 0.1 ppm.

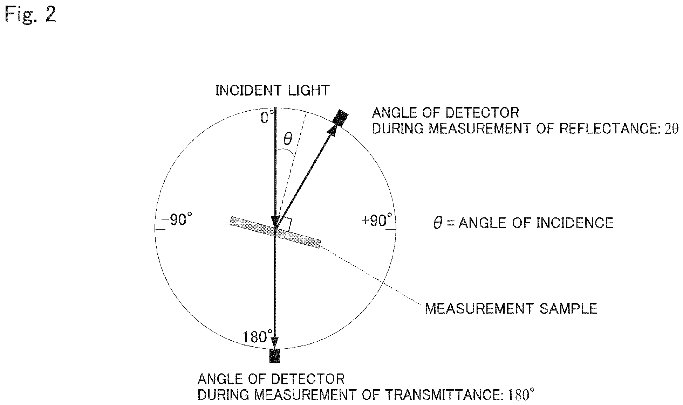

For determination of the absorption coefficient, an angle of incidence $\theta$ of light on the sample was first fixed to 6°, and a reflectance R and a transmittance T were measured. In the measurement, the angle $2\theta$ of a detector during the measurement of the reflectance R was set to 12°, and the angle of the detector during the measurement of the transmittance was set to 180°. In order to reduce noise of the measured values, the measurement was performed by passing incident light through a depolarizer. An absorptivity A was calculated by the following expression (1) from the measured reflectance R and the measured transmittance T on the basis of a principle in which the sum of the reflectance R, the transmittance T, and the absorptivity A was 100%. FIG. 2 is a schematic view illustrating measurement of a reflectance and a transmittance with a spectrophotometer to calculate an absorption coefficient.

[Math. 1]

$$A + R + T = 1 \quad \cdot\cdot\cdot(1)$$

The absorption coefficient is defined as the following expression (2) represented using $\alpha$ in terms of the natural logarithm or $\beta$ in terms of the common logarithm in accordance with the Beer-Lambert law. In the present description, $\beta$ in terms of the common logarithm is used for the absorption coefficient.

[Math. 2]

$$I = I_0 e^{-\alpha x} = I_0 10^{-\beta x} \quad \cdot\cdot\cdot(2)$$

In the expression, x represents the length of a sample through which light is passed, $I_0$ represents the intensity of light immediately before light travels the distance x in the sample, and I represents the intensity of light after light travels only the distance x in the sample. The absorptivity A can be represented by the following expression (3) using $I_0$ and I.
[Math. 3]

$$A = \frac{I_0 - I}{I_0} = 1 - 10^{\beta x} \quad \cdot \ \cdot \ \cdot (3)$$

The absorption coefficient $\beta$ is represented by the following expression (4) from the expression (1) and the expression (3).
[Math. 4]

$$\beta = -\frac{1}{x} \log_{10}(R + T) \quad \cdot \ \cdot \ \cdot (4)$$

The reflectance R and the transmittance T of the sample having the thickness x (cm) were measured, and in the present description, the absorption coefficient $\beta$ ($cm^{-1}$) was calculated by the expression (4).
In a method for deriving the absorption coefficient, the absorption coefficient can also be calculated by the following expression (5) in consideration of multiple reflection in the sample, but it should be noted that the calculated absorption coefficient is slightly different from the value calculated by the expression (4). All the absorption coefficients in the present embodiments are the absorption coefficients calculated by the definition of the expression (4).
[Math. 5]

$$\beta = \frac{1}{x} \{\log_{10}(1 - R) - \log_{10}(T)\} \quad \cdot \ \cdot \ \cdot (5)$$

In Example 1, the absorption coefficient calculated by the expression (4) as described above is as described below.
(1) The absorption coefficient at a wavelength of 470 nm was 0.0039 $cm^{-1}$, (2) the absorption coefficient at a wavelength of 600 nm was 0.0006 $cm^{-1}$, and (1)-(2) was 0.0033 $cm^{-1}$.

[Example 2]

Next, crystal growth and measurement of a platinum concentration and an absorption coefficient were performed under the same conditions as in Example 1 except that the material for the crucible was changed to a platinum-iridium alloy having a platinum ratio of 50%. As a result, the platinum concentration was 0.8 ppm. (1) The absorption coefficient at a wavelength of 470 nm was 0.0079 $cm^{-1}$, (2) the absorption coefficient at a wavelength of 600 nm was 0.0004 $cm^{-1}$, and (1)-(2) was 0.0075 $cm^{-1}$.

[Comparative Example 1]

Next, crystal growth and measurement of a platinum concentration and an absorption coefficient were performed under the same conditions as in Example 1 except that the material for the crucible was changed to pure platinum. As a result, the platinum concentration was 1.2 ppm. (1) The absorption coefficient at a wavelength of 470 nm was 0.0110 $cm^{-1}$, (2) the absorption coefficient at a wavelength of 600 nm was 0.0007 $cm^{-1}$, and (1)-(2) was 0.0103 $cm^{-1}$.
The results of Examples 1 and 2 and Comparative Example 1 are summarized in Table 1.

[Table 1]

| | | Example 1 | Example 2 | Comparative Example 1 |
|---|---|---|---|---|
| Pt concentration (ppm) | | 0.3 | 0.8 | 1.2 |
| (1) | Light absorption coefficient at wavelength of 470 nm ($cm^{-1}$) | 0.0039 | 0.0079 | 0.0110 |

(continued)

|  |  | Example 1 | Example 2 | Comparative Example 1 |
|---|---|---|---|---|
| (2) | Light absorption coefficient at wavelength of 600 nm (cm⁻¹) | 0.0006 | 0.0004 | 0.0007 |
| (1) - (2) | Difference | 0.0033 | 0.0075 | 0.0103 |

When a transition metal other than platinum is also in the LN crystal as an impurity, the absorption peak at about 470 nm may be generated. Thus, elements other than platinum in Examples 1 and 2 and Comparative Examples 1 and 2 were also analyzed by ICP-MS, but an element exhibiting correlation with the absorption coefficient at 470 nm was not found. Table 2 lists the analysis results of typical transition metal elements by ICP-MS.

[Table 2]

|  |  |  | (ppm by mass) |
|---|---|---|---|
|  | Example 1 | Example 2 | Comparative Example 1 |
| Pt concentration | 0.3 | 0.8 | 1.2 |
| Fe concentration | 1.8 | 1.4 | 1.4 |
| Ni concentration | 0.1 | 0.1 | <0.1 |
| Cr concentration | 0.3 | 0.3 | 0.3 |
| Cu concentration | 0.1 | <0.1 | <0.1 |

The aforementioned results show that a reduction in platinum impurity concentration in crystal growth suppresses the absorption peak at about 470 nm. When the platinum impurity concentration in crystal growth is 0.1 ppm or less, it was confirmed that the difference between the light absorption coefficient at a wavelength of 470 nm and the light absorption coefficient at a wavelength of 600 nm is 0.01 cm⁻¹ or less. It was confirmed that the LN single crystal according to the aspect of the embodiment has characteristics of having low absorption of light having a wavelength in the visible light region.

The technical range of the present invention is not limited to the aspects described in the embodiments described above. One or more of the requirements described in the embodiments may be omitted. The requirements described in the embodiments can be appropriately combined. For example, in the single crystal of the present embodiment, the production method of the present embodiment and items described in Examples can be appropriately combined, and in the production method of the present embodiment, the single crystal of the present embodiment and the items described in Examples can be appropriately combined. The contents of all the references cited in Japanese Patent Application No. 2023-090005 and the aforementioned embodiments are incorporated in some of the description as long as they are permitted under law. It is obvious that the lithium niobate single crystal and the production method described in the present embodiment are also applicable to lithium niobate of a stoichiometric composition, a congruent composition, and other compositions, and a variety of lithium niobate single crystals to which a substance is added like a dope without departing from the spirit of the present invention.

## Claims

1. A lithium niobate single crystal having a platinum concentration in the single crystal of 1.0 ppm or less.

2. The lithium niobate single crystal according to claim 1, having a platinum concentration in the single crystal of 0.5 ppm or less.

3. A lithium niobate single crystal having a difference between a light absorption coefficient at a wavelength of 470 nm and a light absorption coefficient at a wavelength of 600 nm of 0.01 cm⁻¹ or less.

4. The lithium niobate single crystal according to claim 3, having a light absorption coefficient at a wavelength of 470 nm of 0.01 cm⁻¹ or less.

5. AR glasses using the lithium niobate single crystal according to any one of claims 1 to 4 as a waveguide.

6. A method for producing a lithium niobate single crystal, the method comprising adjusting a content of platinum in a crucible so that a platinum concentration in a grown single crystal is 1.0 ppm or less, the crucible being used in growth of the single crystal and containing platinum as a material.

Fig. 1

<u>10</u>

Fig. 2

INCIDENT LIGHT

ANGLE OF DETECTOR
DURING MEASUREMENT OF REFLECTANCE: $2\theta$

$\theta$ = ANGLE OF INCIDENCE

MEASUREMENT SAMPLE

ANGLE OF DETECTOR
DURING MEASUREMENT OF TRANSMITTANCE: $180°$

## INTERNATIONAL SEARCH REPORT

| International application No. |
| --- |
| **PCT/JP2024/018912** |

| A. CLASSIFICATION OF SUBJECT MATTER |
| --- |
| *C30B 29/30*(2006.01)i<br>FI: C30B29/30 A |
| According to International Patent Classification (IPC) or to both national classification and IPC |

| B. FIELDS SEARCHED |
| --- |
| Minimum documentation searched (classification system followed by classification symbols)<br><br>C30B29/30 |
| Documentation searched other than minimum documentation to the extent that such documents are included in the fields searched<br><br>Published examined utility model applications of Japan 1922-1996<br>Published unexamined utility model applications of Japan 1971-2024<br>Registered utility model specifications of Japan 1996-2024<br>Published registered utility model applications of Japan 1994-2024 |
| Electronic data base consulted during the international search (name of data base and, where practicable, search terms used)<br><br>JSTPlus/JST7580 (JDreamIII) |

| C. DOCUMENTS CONSIDERED TO BE RELEVANT |
| --- |

| Category* | Citation of document, with indication, where appropriate, of the relevant passages | Relevant to claim No. |
| --- | --- | --- |
| X<br>Y<br>A | JP 2018-100202 A (SUMITOMO METAL MINING CO., LTD.) 28 June 2018 (2018-06-28)<br>paragraphs [0035]-[0044] | 1-2<br><br>5<br>3-4, 6 |
| X<br>Y<br>A | JP 5-97591 A (HITACHI METALS, LTD.) 20 April 1993 (1993-04-20)<br>paragraph [0018] | 3-4<br><br>5<br>1-2, 6 |
| Y<br><br>A | LEACH, Christopher J. et al. Applied Sciences. Considerations of Curvature for a Near-Eye Holo-Video Display. 01 October 2020, vol. 10, no. 19, 6888<br>pp. 1-2, 1. Introduction | 5<br><br><br>1-4, 6 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **27 June 2024** | **09 July 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

<table>
<tr><td colspan="2">International application No.</td></tr>
<tr><td colspan="2">**PCT/JP2024/018912**</td></tr>
</table>

| Patent document cited in search report | | Publication date (day/month/year) | Patent family member(s) | Publication date (day/month/year) |
|---|---|---|---|---|
| JP | 2018-100202 A | 28 June 2018 | (Family: none) | |
| JP | 5-97591 A | 20 April 1993 | (Family: none) | |

Form PCT/ISA/210 (patent family annex) (July 2022)

**REFERENCES CITED IN THE DESCRIPTION**

**Patent documents cited in the description**

- JP H0196095 A

- JP 2023090005 A